# EUROPEAN PATENT SPECIFICATION

(11) **EP 0 751 477 B1**
(45) Date of publication and mention of the grant of the patent: **14.04.2004**
(21) Application number: 96303199.2
(22) Date of filing: 08.05.1996
(51) Int. Cl.: G06K 19/07, G06K 19/073, G11C 7/00

(54) **IC card memory having a specific recording format and method for recording/reproducing a digital voice therefrom**
IC-Kartenspeicher mit besonderem Aufzeichnungsformat und zugehöriges Verfahren zur Aufzeichnung und Wiedergabe einer digitalen Stimmaufzeichnung
Mémoire à carte à puce ayant un format d'enregistrement spécifique et méthode pour enregistrer/reproduire une voix digitale à partir de celle-ci

(30) Priority: 28.06.1995 KR 1785695
(43) Date of publication of application: 02.01.1997
(73) Proprietor: Samsung Electronics Co., Ltd., Suwon-city, Kyungki-do 441-370 (KR)
(72) Inventor: Kim, Byoung-Jun, Suwon-City, Kyungki-do (KR)
(74) Representative: Chugg, David John

(56) References cited:
- EP-A- 0 400 475
- EP-A- 0 523 452
- US-A- 4 584 681
- US-A- 4 930 129
- ANONYMOUS: "Memory System Reliability Enhancement by Module Swapping. April 1983." IBM TECHNICAL DISCLOSURE BULLETIN, vol. 25, no. 11B, 1 April 1983 (1983-04-01), pages 5858-5859, XP002129029 New York, US
- PATENT ABSTRACTS OF JAPAN vol. 1995, no. 06, 31 July 1995 (1995-07-31) & JP 07 079403 A (NIKON CORP), 20 March 1995 (1995-03-20)
- PATENT ABSTRACTS OF JAPAN vol. 018, no. 441 (P-1788), 17 August 1994 (1994-08-17) & JP 06 139131 A (TOSHIBA CORP), 20 May 1994 (1994-05-20)

## Description

The present invention relates to an IC card memory in a digital voice recording/reproducing apparatus, and more particularly to such an IC card memory having a specific recording format and a method for recording/reproducing a digital voice therefrom.

Up to now, there are no particular operations to be taken in order to record an analog input voice signal on a magnetic tape. Thus a recording of the analog voice signal in the magnetic tape brings about degradation in voice quality or storage.

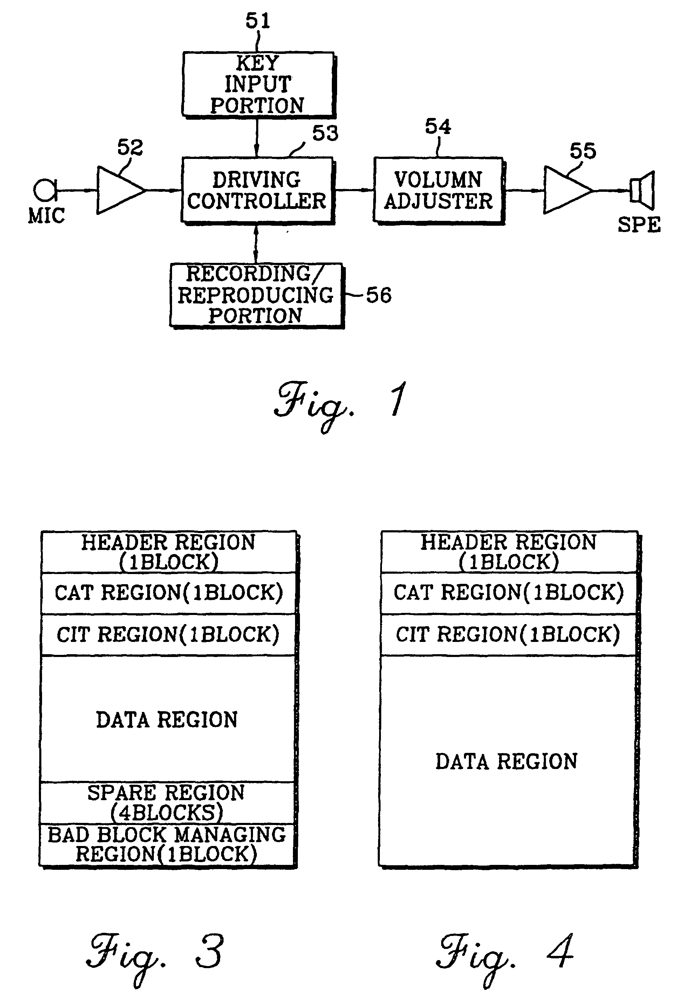

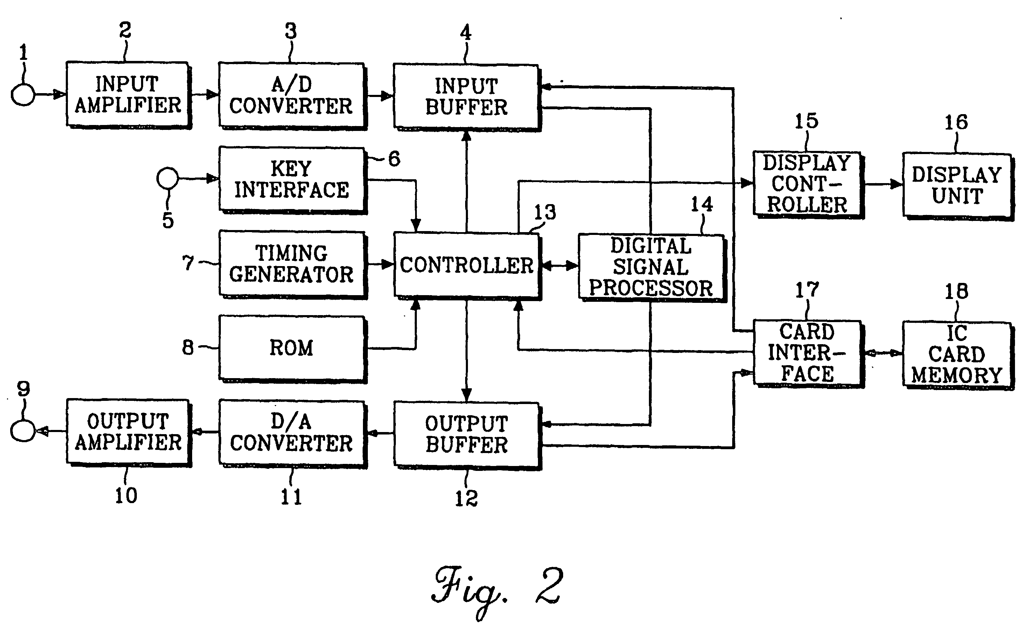

A general analog recording/reproducing apparatus includes, as shown in Figure 1, a microphone MIC for receiving an analog voice signal, a recording amplifier 52 for amplifying a recording signal, a key input portion 51 for receiving an operating signal, a driving controller 53 for controlling and driving a magnetic tape, a recording/reproducing portion 56 for recording/reproducing a modulated signal from the magnetic tape, a reproducing amplifier 55 for amplifying a reproducing signal, and a speaker SPK for reproducing and generating a signal.

The analog voice signal received through the microphone MIC is modulated according to a recording frequency of a magnetic head. The modulation determines a voltage to be transmitted to the head on the basis of an amplitude of the input signal. The modulated signal is sent to the magnetic head and recorded in the travelling magnetic tape. If a high voltage flows into the head, a strong magnetic field is formed according to the characteristic of the magnetic head. The magnetic field causes a signal to be recorded in the magnetic tape. During reproducing, the signal recorded in the magnetic tape is read and then converted to an electric signal according to its magnitude. The converted signal is transmitted to a mounted speaker or headphone, or an external line terminal.

However, since the analog voice recording/reproducing apparatus has a structure in which the input analog signal is sent to the magnetic head to create the magnetic field, individual input signals are machine indistinguishable and there is no additional distinguishing information on the input signal. Therefore, it is impossible to be applied to other fields such as a computer, communication, etc. Further since storage of recording is influenced by surrounding circumstances, the signal is unstable.

If a digital signal is used instead of the analog signal, there is almost no degradation in voice quality and an error in recording and reproducing. Moreover, it is possible to more easily classify recorded information, and it is of wide application.

An IC card memory is presently coming to the fore as a recording medium of the next generation. The IC card memory has better properties in portability and data storage than other recording media such as an analog tape, a compact disk and a minidisk, etc. However, the development of applicable equipment is still insufficient, since a memory device suitable therefor is high in price and there is no standard recording format.

It is therefore an aim of embodiments of the invention to provide an IC card memory having a standard recording format and a method for recording/reproducing a digital voice therefrom.

EP-A-0,400,475 (Fuji Photo Film) discloses a storage management system for a memory card, which has a storage area divided into clusters. The storage area includes a management table for indicating relationships between clusters and a directory for indicating a start cluster in a group of mutually associated information. The tables are set up after a searching operation in use, prior to writing information in the memory card. Claim 1 is delimited against this prior art.

According to the present invention there is provided an IC card memory as set forth in claim 1 appended hereto.

Also according to the present invention there is provided a method for recording and/or reproducing digital voice data from an IC card memory, as set forth in claim 6 appended hereto.

Preferred features of the present invention will be apparent from the dependent claims, and the description which follows.

In one aspect of the present invention there is provided an IC card memory comprising: a data region storing digital voice data in one or more variable-length chapters, each chapter comprising one or more fixed-length clusters, each cluster comprising a predetermined number of data blocks; and a system region, comprising: a header region storing header information on said IC card memory and information on a format; a chapter attribute table region storing information related to the or each chapter of data recorded in the data region; a cluster index table region storing an address of the one or each cluster index corresponding to the or each chapter of recorded data; and a spare region; and a bad block managing region to manage bad blocks occurring in the system region, the bad block managing region including a check array, the check array being arranged to indicate whether the bad block managing region has been relocated to the spare region following occurrence of a bad block.

Preferably, the spare region provides for an occurrence of a bad block among said header region, chapter attribute table region, cluster index table region, or data region.

Preferably, said bad block managing region is arranged for managing a bad block occurring in said data region.

Preferably, a start address of said cluster index table region is stored in the last bit of said chapter attribute table region.

Preferably, said start address of said cluster index table region designates one cluster index address of said cluster index table region, and wherein the designated cluster index address designates other cluster index addresses.

According to a second aspect of the present invention there is provided a method for recording and/or reproducing digital voice data on from an IC card memory as described above, comprising the steps of: sensing whether said IC card memory is inserted; checking whether a check array in a bad block managing region is correct, in that the check array contains an expected standard value; if the check array is incorrect, then searching blocks of a spare region until a block in the spare region is judged to be the bad block managing region; if the check array is correct, or once the bad block managing region has been found in the spare region, then reading a header region and loading a chapter attribute table and a cluster index table, to enable access to recorded data in a data region.

Preferably, the method further comprises the step of if said check array of said bad block managing region is not correctly perceived, then positioning the bad block managing region in the spare region.

For a better understanding of the invention, and to show how embodiments of the same may be carried into effect, reference will now be made, by way of example, to the accompanying diagrammatic drawings, in which:
Figure 1 is a block diagram of a general analog voice recording/reproducing apparatus;
Figure 2 is a block diagram of a digital voice recording/reproducing apparatus using an IC card memory according to an embodiment of the present invention;
Figure 3 shows a format of a recordable memory card;
Figure 4 shows a format of a reproducing-only memory card;
Figure 5 is a flow chart showing a recording/reproducing memory card loading sequence according to an embodiment of the present invention;
Figure 6 is a flow chart showing a reproducing memory card loading sequence according to embodiments of the present invention;
Figure 7 shows an internal structure of a memory card; and
Figure 8 shows a connection structure between a chapter attribute table (CAT) and a cluster index table (CIT).

In the following description, specific details such as circuit constituents etc. are set forth to provide a more through understanding of the invention. It will be apparent, however, to one skilled in the art, that the invention may be practised without these specific details. In other instances, well known functions or constructions have not been described so as not to obscure the invention.

Referring to Figure 2, there is shown a digital voice recording/reproducing apparatus using an IC card memory 18. The IC card memory 18 stores digital voice data. A card interface 17 checks whether the IC card memory 18 is in contact with the digital voice recording/reproducing apparatus. If the insertion of the IC card memory 18 is sensed, the card interface 17 supplies a power source, a clock, data; etc., or reads out data from the IC card memory 18. A controller 13 controls the entire operation of the digital voice recording/reproducing apparatus. A voice input terminal 1 receives a voice through a microphone etc. An input amplifier 2 amplifies the voice received through the voice input terminal 1. An analog-to-digital (A/D) converter 3 digitizes the amplified voice signal. An input buffer 4 temporarily stores the digitized voice signal (hereinafter, referred to as a first digital voice signal) or a second digital voice signal provided through the card interface 17 from the IC card memory 18.

A key input terminal 5 sends various commands and data to the digital voice recording/reproducing apparatus. A key interface 6 causes the controller 13 to sense key input data received through the key input terminal 5. A timing generator 7 checks and controls timing. A ROM stores data and programs. A digital signal processor 14 digital-processes a signal provided from the input buffer 4 and may generate either a compressed form or non-compressed form as output data. An output buffer 12 temporarily stores the signal processed from the digital signal processor 14. A digital-to-analog (D/A) converter 11 converts the a digital signal generated from the output buffer 12 to an analog signal. An output amplifier 10 amplifies the analog-converted voice signal. A voice output terminal 9 generates the amplified voice signal through a speaker etc. A display controller 15 displays a digital voice recording/reproducing process on a display unit 16 by the control of the controller 13.

A recording format according to the present invention is classified into formats for use in a recording/reproducing system and a reproducing-only system. Each format consists of a system region and a data region. Figure 3 shows the format of a recordable memory card. The system region is divided into a header region, a chapter attribute table (CAT) region, a cluster index table (CIT) region, a spare region and a bad block managing region. Figure 4 shows the format of a reproducing-only memory card. The system region is divided into the header region, the CAT region and the CIT region. The system region implements the same function irrespective of the recording/reproducing system and the reproducing-only system. Therefore, a description will now be given on the basis of the format of the recording/reproducing system.

Information on the entire IC card memory and format is listed on the header region. The following Table 1 shows the contents of the header region in the recording/reproducing system. Only 256 bytes are used and others are empty as a reserved region.

**Table 1**

| Offset (Bytes) | Title | Contents |
|---|---|---|
| 08h (8) | Format check code | Check whether an inserted IC card memory is FCAF format. "Ffh, 53h, 41h, 4Dh, 53h, 55h, 4Eh, 47h" |
| 08h (8) | Format name | Basic IC card memory format name. ASCII code of "FCAF_1.0". |
| 10h (18) | System ID | Record manufacturer and company name up to 16 characters by ASCII code. |
| 20h (6) | Format date and time | Record date and time initially formatting IC card memory. "xxh,xxh (year), xxhxx (month), hxxhxx (day)" "xxhxxh (hour), xxhxxh (minute), xxhxxh (second)" Record only a value added to 1994 as a year and record time by the twenty-four-hour system. |
| 26h (1) | Card type indicator | IC card memory type. Indicate whether IC card memory is recordable (2 more significant bits): 00-read-only, 11-recordable. Used memory (6 less significant bits). x0-ROM, x1-SRAM, x2-EPROM, x3-EEPROM, x4-NAND Flash, X5-NOR Flash, others-reserved |
| 27h (1) | Number of blocks per cluster | Denote by a binary number that one cluster has how many blocks (at present 4096 bytes). |
| 28h (4) | Reserved region | Fill with "FFH". |
| 2Ch (4) | Start block number of CAT | Block number in which CAT is started (=block address). |
| 30h (2) | Number of CAT entry | The total number of CATs generated during formatting. For example, one of 128, 256, 512 and 1024. |
| 32h (4) | Start block number of CITs | Block number in which CIT is started (=block address). |
| 36h (3) | Number of CIT entry | The total number of CITs generated during formatting. One CIT corresponds to one cluster. |
| 39h (1) | Number of copied CITs | The number of copied CITs to be used when one CIT is damaged. |
| 3Ah (4) | Reserved region | Fill with "FFH". |
| 3Eh (1) | Number of recorded chapters | The total number of recorded chapters. The current maximum number is 128. |
| 3Fh (1) | Number of start blocks of data region | The magnitude of data region (byte unit). The most significant byte is 3 and the least significant byte is 0. The total number of blocks - (spare region + bad block managing region + header region + CAT region + CIT region) |
| 43h (4) | Total number of blocks of data region | The total number of blocks of data region. The actual magnitude of data region is obtained by subtracting the total number of bad blocks within data region from the above magnitude of data region. |
| 47h (2) | Number of bad blocks | Start block number of the data region (= block address). |
| 49h (183) | Reserved region | Fill with "FFH". |

The following Table 2 shows the contents of the header region in the reproducing-only system.

**Table 2**

| Offset (Bytes) | Title | Contents |
|---|---|---|
| 08h (8) | Format check code | Check whether an inserted IC card memory is FCAF format. "Ffh, 53h, 41h, 4Dh, 53h, 55h, 4Eh, 47h" |
| 08h (8) | Format name | Basic IC card memory format name. ASCII code of "FCAF_1.0". |
| 10h (18) | System ID | Record manufacturer and company name up to 16 characters by ASCII code. |
| 20h (6) | Format date and time | Record date and time initially formatting IC card memory. "xxh,xxh (year), xxhxx (month), hxxhxx (day)" "xxhxxh (hour), xxhxxh (minute), xxhxxh (second)" Record only a value added to 1994 as a year and record time by the twenty-four-hour system. |
| 26h (1) | Card type indicator | IC card memory type. Indicate whether IC card memory is recordable (2 more significant bits): 00-read-only, 11-recordable. Used memory (6 less significant bits). x0-ROM, x1-SRAM, x2-EPROM, x3-EEPROM, x4-NAND Flash, X5-NOR Flash, others-reserved. |
| 27h (1) | Number of blocks per cluster | Denote by a binary number that one cluster has how many blocks (at present 4096 bytes). |
| 28h (4) | Reserved region | Fill with "FFH". |
| 2Ch (4) | Start block number of CAT | Block number in which CAT is started (=block address). |
| 30h (2) | Number of CAT entry | The total number of CATs generated during formatting. For example, one of 128, 256, 512 and 1024. |
| 32h (4) | Start block number of CITs | Block number in which CIT is started (=block address). |
| 36h (3) | Number of CIT entry | The total number of CITs generated during formatting. One CIT corresponds to one cluster. |
| 39h (1) | Number of copied CITs | The number of copied CITs to be used when one CIT is damaged. |
| 3Ah (4) | Reserved region | Fill with "FFH". |
| 3Eh (1) | Number of recorded chapters | The total number of recorded chapters. The current maximum number is 128. |
| 3Fh (1) | Number of start blocks of data region | The magnitude of data region (byte unit). The most significant byte is 3 and the least significant byte is 0. |
| 43h (4) | Total number of blocks of data region | The total number of bad blocks within data region. |
| 47h (185) | Reserved region | Fill with "FFH". |

The following Table 3 shows the contents of the CAT region. The CAT region is a region collecting information related to a chapter. The chapter is recorded data until an execution is stopped after one recording operation is executed. One CAT entry consists of 32 bytes, and information concerning up to 128 chapters are recordable. That is, since 32 x 128 = 4,096 (=4K) bytes, one block is all filled. In one page, only 256 bytes are used, and other 8 bytes are used to record additional information related to the page.

**Table 3**

| Offset (Bytes) | Title | Contents |
|---|---|---|
| 00h (12) | Chapter name | Corresponding chapter name. This value is more effective in MASK ROM. |
| 0Ch (3) | Recording date | Recording start date. "xxhxxh (year), xxhxxh (month), xxhxxh (day)" |
| 0Fh (3) | Recording time | Recording start time. "xxhxxh (hour), xxhxxh (minute), xxhxxh (second)" |
| 12h (4) | Chapter size | Chapter size (byte unit). |
| 16h (6) | Chapter mode | Recorded data mode. For example, voice + video + text + etc. Indicate characteristic for respective data. Record voice, video, text by 2 bytes, respectively, from the more significant byte. |
| 1Ch (2) | Reserved region | Fill with "FFH". |
| 1Eh (2) | CIT start number | CIT number in which corresponding chapter is started (block and page addresses). |

The following Table 4 indicates the CIT region storing information related to the cluster. The cluster is a basic unit of erase and management. One cluster indicates one or more block. Each cluster index (CI) is 2 bytes and indicates an address of actual data. In other words, an address of one cluster index corresponding to the recorded block is recorded. Specific data except the CIT address is as follows:
FFFFh : unused cluster
FFF5h : bad cluster
Where "FFFAh" is recorded in the last recorded cluster. That is, a successively connected cluster index is read until "FFFAh" appears. A cluster start address is recorded in the last 2 bytes of a corresponding CAT.

**Table 4**

| | | | |
|---|---|---|---|
| xxxxh | xxxxh | .... | xxxxh |
| xxxxh | xxxxh | .... | xxxxh |
| . | . | . | . |
| . | . | . | . |
| xxxxh | xxxxh | .... | xxxxh |

The data region is for recording data. In one page, 256 bytes record only pure data and other 8 bytes record various control signals and additional information corresponding each page. The page information is set as follows:
bytes 7 - 4 : reserved regions
byte 3 : indicate whether it is end of data (EOD)
byte 2 : end address of data
bytes 1 - 0 : reserved regions

If the above information is recorded together with data, the accurate magnitude and end can be known during reproducing. The end of data (EOD) has nearly the same meaning as end of file (EOF) used in a computer.

The spare region has 4 blocks as a basic value. This region is previously prepared for the case that any one of the header, CAT, CIT and bad block managing regions is judged to a bad block. The number of the spare regions is indicated in the header region. The start address of the spare region is predetermined, and 4 blocks therefrom are used. Even if there is no a bad block in the system, the data region can be recorded only up to the start address of the spare region. Therefore, the spare region should be necessarily emptied. If the data region is replaced (copied) with one of the system regions, this is recorded in the bad block managing region. When information on a corresponding address and a replaced region is recorded and the card is again inserted, the system regions can be read. If there is a bad block within the data region, the bad block is not used.

The following Table 5 indicates the contents of the bad block managing region. The bad block managing region is firstly read together with the header region in the system. To correctly read the data region, and the system region including the header region, the bad block managing region should be read. The bad block generated in the data region is managed in the bad block managing region so as not to be reused.

**Table 5**

| Offset (Bytes) | Title | Contents |
|---|---|---|
| 00h (16) | Check array | "Ffh, Ffh, AAh, 55h, 0Fh, F0h, 24h, DBh, 03h, 0Ch, 30h, C0h, 33h, 66h, Cch, 99h" |
| 10h (2) | Version | FCAF version number. |
| 12h (2) | Space region number | The total number of spare regions (blocks) within IC card memory. |
| 14h (8) | Space region address | Block address of each spare region. |
| 1Ch (4) | Contents of spare region | The contents of each spare region. ( a replaced system name) |
| 20h (2) | Number of blocks | The total number of blocks within the IC card memory. |
| 22h (2) | Number of bad blocks | The total number of bad blocks within the data region of the IC card memory. |
| 24h (2012) | Bad block address | Address of each bad block. |

In the above Table 5, the check array indicates whether the bad block managing region is correct. If the check array is not correctly perceived, the bad block managing region is positioned in the spare region. The check array is a standard for searching for the bad block managing region from the spare regions.

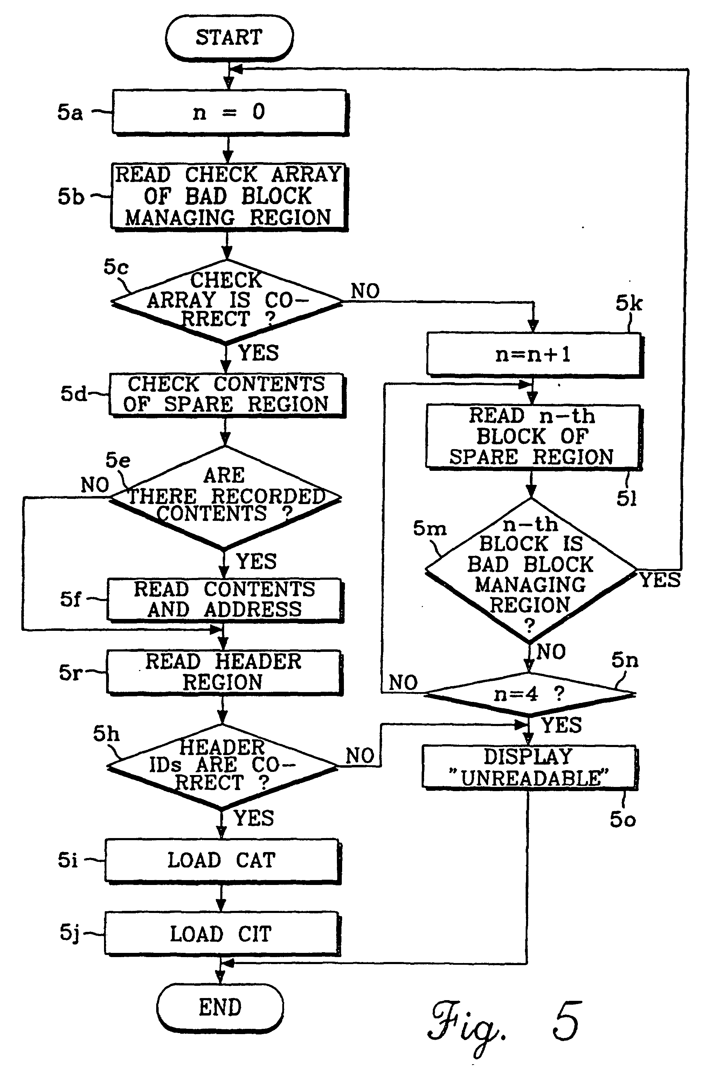

Figure 5 shows a recording/reproducing memory card loading sequence. If the insertion of the card is sensed, whether the check array is correct is checked by reading the check array of the bad block managing region (steps 5a-5d). If there are recorded contents in the spare region, the contents and an address are read and the header region is read (steps 5e-5g). If header identifications (Ids) are correct, the CAT and the CIT are loaded (steps 5h-5j). Meanwhile, if the check array of the bad block managing region is incorrect, blocks of the spare region are repeatedly read until the block is judged to the bad block managing region (steps 5k-5n). If the header Ids are incorrect, a message "unreadable" is displayed on the display unit 16 (step 5o).

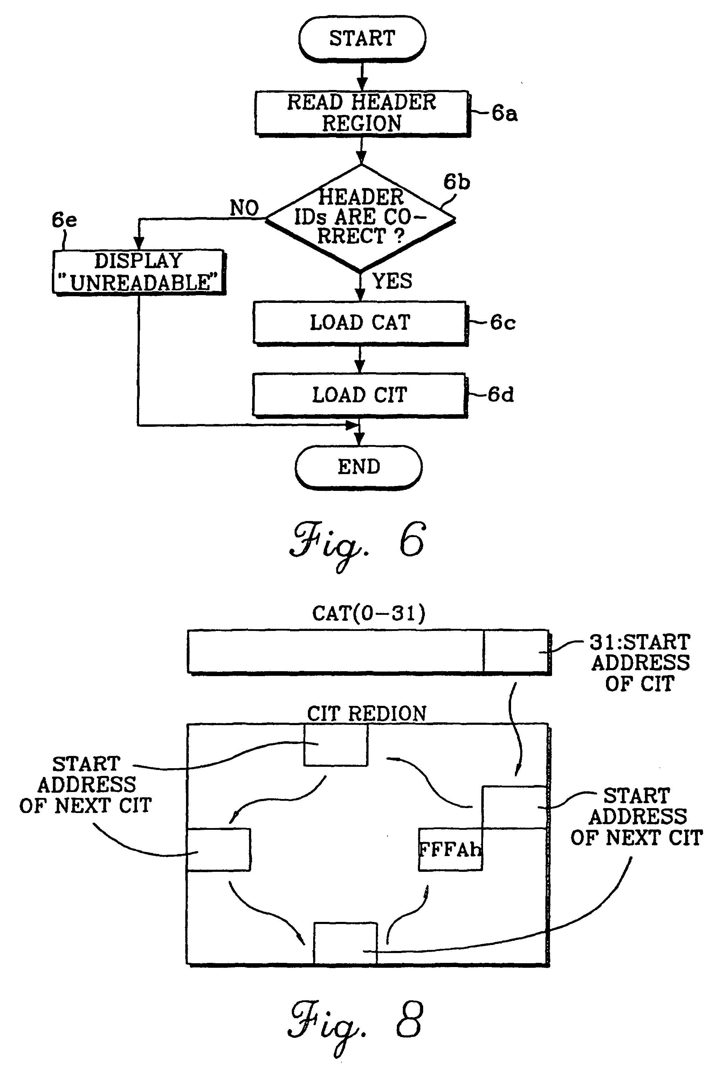

Figure 6 shows a reproducing memory card loading sequence. If the insertion of the card is sensed, the header Ids are checked by reading the header region to see if they are correct (steps 6a and 6b). If the header Ids are correct, the CAT and the CIT are loaded (steps 6c and 6d). If the header Ids are incorrect, a message "unreadable" is displayed on the display unit 16 (step 6e).

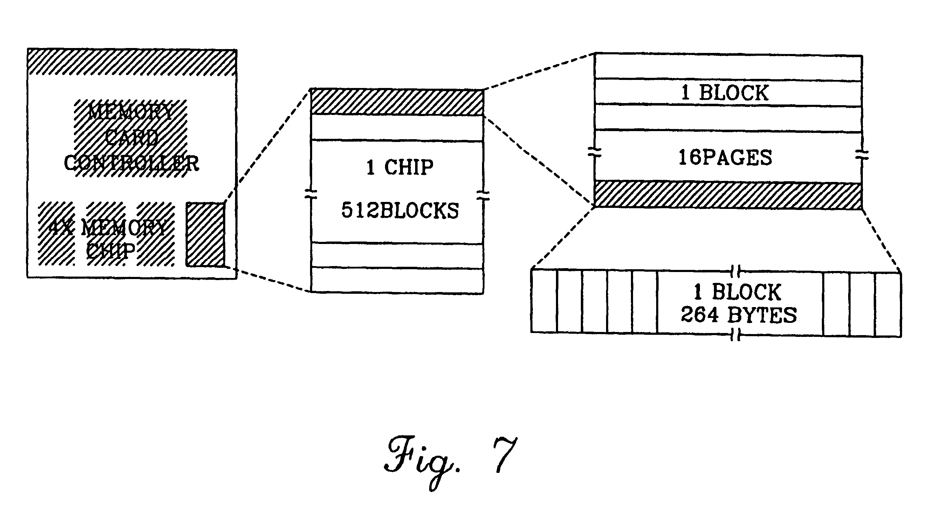

Figure 7 shows an internal structure of the memory card. One memory card consists of one or more memory chip. One memory chip contains a prescribed number of blocks each having a prescribed number of pages. One page includes a prescribed number of columns each having one or more memory cell (byte). For example, one memory card has 4 chips each having 512 blocks. One block consists of 16 pages each including 256 columns (bytes).

The recording/reproducing memory card consists of a recordable/reproducible semiconductor memory chip such as a EEPROM (Electrically Erasable and Programmable Read Only Memory) or a flash memory. The recording memory card consists of a reproducible semiconductor memory chip such as a mask ROM.

Figure 8 shows a connection structure between the CIT and the CAT. Since the CIT is an important factor for data recorded in the data region, a number of the CITs are copied to provide against damage. If the data region varies, the CIT should be corrected. When repeating recording and erasing, although many data pieces occur, the free recording and erasing can be ensured.

As described above, since the recording format is united, it is convenient to develop a product and to produce commercially available commodities. Such an IC memory card has better properties in portability, data storage, etc. than other recording media such as an analog tape, a compact disk, a minidisk, etc.

While there has been shown and described what is considered to a preferred embodiment of the invention, it will be apparent that various changes and modifications are possible. Therefore, the invention should be understood as including all possible embodiments which fall under the scope of the appended claims.

## Claims

1. An IC card memory comprising:
a data region (DATA REGION) storing digital voice data in one or more variable-length chapters, each chapter comprising one or more fixed-length clusters, each cluster comprising a predetermined number of data blocks; and
a system region, comprising:
a header region (HEADER REGION) storing header information on said IC card memory and information on a format;
a chapter attribute table region (CAT REGION) storing information related to the or each chapter of data recorded in the data region (DATA REGION);
a cluster index table region (CIT REGION) storing an address of the one or each cluster index corresponding to the or each chapter of recorded data;
**characterised by** :
a spare region (SPARE REGION); and
a bad block managing region (BAD BLOCK MANAGING REGION) to manage bad blocks occurring in the system region, the bad block managing region including a check array, the check array being arranged to indicate whether the bad block managing region has been relocated to the spare region following occurrence of a bad block.

2. An IC card memory as claimed in claim 1, wherein the spare region provides for an occurrence of a bad block among said header region, chapter attribute table region, cluster index table region, or data region.

3. An IC card memory as claimed in claim, 1 or 2, wherein said bad block managing region is arranged for managing a bad block occurring in said data region.

4. An IC card memory as claimed in claim, 1, 2 or 3, wherein a start address of said cluster index table region is stored in the last bit of said chapter attribute table region.

5. An IC card memory as claimed in claim 4, wherein said start address of said cluster index table region designates one cluster index address of said cluster index table region, and wherein the designated cluster index address designates other cluster index addresses.

6. A method for recording and/or reproducing digital voice data on from an IC card memory according to claim 1, comprising the steps of:
sensing whether said IC card memory is inserted;
checking whether a check array in a bad block managing region is correct, in that the check array contains an expected standard value;
if the check array is incorrect, then searching blocks of a spare region until a block in the spare region is judged to be the bad block managing region;
if the check array is correct, or once the bad block managing region has been found in the spare region, then reading a header region and loading a chapter attribute table and a cluster index table, to enable access to recorded data in a data region.

7. A method for recording and reproducing a digital voice as claimed in claim 6, further comprising the step of:
if said check array of said bad block managing region is not correctly perceived, then positioning the bad block managing region in the spare region.

8. A digital voice recording/reproducing apparatus comprising an IC card memory in accordance with any of claims 1 to 5.

9. A digital voice recording/reproducing apparatus arranged to operate in accordance with the method of claim 6 or 7.

## Patentansprüche

1. IC Speicherkarte mit:
einem Daten-Bereich (DATEN-BEREICH), der digitale Sprachdaten in einem oder mehreren Abschnitten variabler Länge speichert, wobei jeder Abschnitt einen oder mehrere Gruppen fester Länge enthält, wobei jede Gruppe eine vorbestimmte Anzahl Datenblöcke enthält; und
einen System-Bereich mit:
einem Kopf-Bereich (KOPF-BEREICH), der Kopfinformationen über die IC Speicherkarte und Informationen über ein Format speichert;
einem Abschnittattributtabellen-Bereich (CAT-BEREICH), der Informationen bezogen auf den einen oder jeden Abschnitt der in dem Daten-Bereich (DATEN-BEREICH) aufgenommenen Daten speichert;
einem Gruppenindextabellen-Bereich (CIT-BEREICH), der eine Adresse des einen oder jedes Gruppenindex entsprechend dem einen oder jedem Abschnitt der aufgenommenen Daten speichert;
**gekennzeichnet durch**:
einen Ersatz-Bereich (ERSATZ-BEREICH); und
einen Fehlerblockverwaltungs-Bereich (FEHLERBLOCKVERWALTUNGS-BEREICH), um schadhafte Blöcke, die im System-Bereich auftreten zu verwalten, wobei der Fehlerblockverwaltungs-Bereich ein Kontrolldatenfeld enthält, wobei das Kontrolldatenfeld dazu ausgelegt ist, anzuzeigen, ob der Fehlerblockverwaltungs-Bereich infolge des Auftretens eines schadhaften Blocks in den Ersatz-Bereich verlegt worden ist.

2. IC Speicherkarte gemäß Anspruch 1, wobei der Ersatz-Bereich für den Fall eines Auftretens eines schadhaften Blocks in dem Kopf-Bereich, Abschnittattributtabellen-Bereich, Gruppenindextabellen-Bereich oder Daten-Bereich vorgesehen ist.

3. IC Speicherkarte gemäß Anspruch 1 oder 2, wobei der Fehlerblockverwaltungs-Bereich ausgelegt ist, um einen in dem Daten-Bereich auftretenden schadhaften Block zu verwalten.

4. IC Speicherkarte gemäß einem der Ansprüche 1 bis 3, wobei eine Startadresse des Gruppenindextabellen-Bereichs in dem letzten Teil des Abschnittattributtabellen-Bereichs gespeichert ist.

5. IC Speicherkarte gemäß Anspruch 4, wobei die Startadresse des Gruppenindextabellen-Bereichs eine Gruppenindexadresse des Gruppenindextabellen-Bereichs bestimmt und wobei die bestimmte Gruppenindexadresse andere Gruppenindexadressen bestimmt.

6. Verfahren zum Aufnehmen und/oder Wiedergeben von digitalen Sprachdaten auf/von einer IC Speicherkarte gemäß Anspruch 1, mit den Schritten:
Erfassen, ob die IC Speicherkarte eingefügt ist;
Überprüfen, ob ein Kontroffdatenfeld, in einem Fehlerblockverwaltungs-Bereich korrekt ist, dahingehend dass das Kontrolldatenfeld einen erwarteten Standardwert enthält;
falls das Kontrolldatenfeld inkorrekt ist, dann Suchen von Blöcken aus einem Ersatz-Bereich, bis ein Block in dem Ersatz-Bereich als der Fehlerblockverwaltungs-Bereich erkannt worden ist;
falls das Kontrolldatenfeld korrekt ist oder sobald der Fehlerblockverwaltungs-Bereich in dem Ersatz-Bereich gefunden worden ist, dann Lesen eines Kopf-Bereichs und Laden einer Abschnittattributtabelle und einer Gruppenindextabelle, um Zugriff auf die aufgenommenen Daten in einem Daten-Bereich zu ermöglichen.

7. Verfahren zum Aufnehmen und Wiedergeben einer digitaler Sprachdaten gemäß Anspruch 6, weiter mit dem Schritt:
falls das Kontrolldatenfeld des Fehlerblockverwaltungs-Bereichs nicht korrekt erkannt ist, dann Anlegen des Fehlerblockverwaltungs-Bereichs im Ersatz-Bereich.

8. Ein Gerät zum Aufnehmen/Wiedergeben digitaler Sprache mit einer IC Speicherkarte gemäß einem der Ansprüche 1 bis 5.

9. Ein Gerät zum Aufnehmen/Wiedergeben digitaler Sprache, das ausgestaltet ist, um gemäß dem Verfahren der Ansprüche 6 oder 7 zu arbeiten.

## Revendications

1. Mémoire à carte à puce, comprenant :
une région de données (RÉGION DONNÉES) stockant des données vocales numériques dans un ou plusieurs chapitres de longueur variable, chaque chapitre comprenant un ou plusieurs groupements de longueur fixe, chaque groupement comprenant un nombre prédéterminé de blocs de données ; et
une région système, comprenant :
une région d'en-tête (RÉGION EN-TÊTE) stockant des informations d'en-tête sur ladite mémoire à carte à puce et des informations concernant un format ;
une région de table d'attributs de chapitres (RÉGION CAT) stockant des informations relatives au ou à chaque chapitre de données enregistrées dans la région de données (RÉGION DONNÉES) ;
une région de table d'indices de groupements (RÉGION CIT) stockant une adresse du ou de chaque indice de groupement correspondant au ou à chaque chapitre de données enregistrées ;
**caractérisée par** :
une région de réserve (RÉGION RÉSERVE) ; et
une région de gestion de blocs défectueux (RÉGION GESTION BLOCS DÉFECTUEUX) pour gérer des blocs défectueux apparaissant dans la région système, la région de gestion de blocs défectueux comprenant un tableau de vérification, le tableau de vérification étant conçu pour indiquer si la région de gestion de blocs défectueux a été déplacée dans la région de réserve après l'apparition d'un bloc défectueux.

2. Mémoire à carte à puce selon la revendication 1, dans laquelle la région de réserve permet de gérer l'apparition d'un bloc défectueux dans ladite région d'entête, ladite région de table d'attributs de chapitres, ladite région de table d'indices de groupements, ou ladite région de données.

3. Mémoire à carte à puce selon la revendication 1 ou 2, dans laquelle ladite région de gestion de blocs défectueux est conçue pour gérer un bloc défectueux apparaissant dans ladite région de données.

4. Mémoire à carte à puce selon la revendication 1, 2 ou 3, dans laquelle une adresse de départ de ladite région de table d'indices de groupements est stockée dans le dernier bit de ladite région de table d'attributs de chapitres.

5. Mémoire à carte à puce selon la revendication 4, dans laquelle ladite adresse de départ de ladite région de table d'indices de groupements désigne une adresse d'indice de groupement de ladite région de table d'indices de groupements, et dans laquelle l'adresse d'indice de groupement désignée désigne d'autre adresses d'indices de groupements.

6. Procédé pour enregistrer et/ou reproduire des données vocales numériques sur/depuis une mémoire à carte à puce selon la revendication 1, comprenant les étapes consistant à :
détecter si ladite mémoire à carte à puce est insérée ;
vérifier si un tableau de vérification dans une région de gestion de blocs défectueux est correcte, c'est-à-dire si le tableau de vérification contient une valeur standard attendue ;
si le tableau de vérification est incorrect, rechercher alors des blocs d'une région de réserve jusqu'à ce qu'un bloc dans la région de réserve soit considéré comme étant la région de gestion de blocs défectueux ;
si le tableau de vérification est correct, ou une fois que la région de gestion de blocs défectueux a été trouvée dans la région de réserve, lire alors la région d'en-tête et charger une table d'attributs de chapitres et une table d'indices de groupements, pour permettre un accès aux données enregistrées dans une région de données.

7. Procédé d'enregistrement et de reproduction d'une voix numérique selon la revendication 6, comprenant en outre l'étape consistant à :
si ledit tableau de vérification de ladite région de gestion de blocs défectueux n'est pas correctement perçue, positionner alors la région de gestion de blocs défectueux dans la région de réserve.

8. Appareil d'enregistrement/reproduction de voix numérique comprenant une mémoire à carte à puce selon l'une quelconque des revendications 1 à 5.

9. Appareil d'enregistrement/reproduction de voix numérique conçu pour fonctionner conformément au procédé de la revendication 6 ou 7.
